# EUROPÄISCHE PATENTANMELDUNG

(11) **EP 3 696 977 A1**
(43) Veröffentlichungstag der Anmeldung: **19.08.2020**
(21) Anmeldenummer: 19157079.5
(22) Anmeldetag: 14.02.2019
(51) Int. Cl.: H03K 17/082

(54) **ELEKTRONISCHER SCHALTER ALS STROMBEGRENZER UND DÄMPFUNGSELEMENT**

(71) Anmelder: Siemens Aktiengesellschaft, 80333 München (DE)
(72) Erfinder: Gaudenz, Markus Matthias, 91056 Erlangen (DE)

(57) **Zusammenfassung**

Die Erfindung betrifft einen elektronischen Schalter (1) aufweisend einen Halbleiterschalter (2) mit einer Ansteuerschaltung (3). Um den elektronischen Schalter (1) zu verbessern, wird vorgeschlagen, dass die Ansteuerschaltung (3) derart ausgebildet ist, den Halbleiterschalter (2) in einem eingeschalteten Zustand, in einem ausgeschalteten Zustand oder im Linearbetrieb zu betreiben. Weiter betrifft die Erfindung ein Energieversorgungssystem (10) aufweisend einen derartigen elektronischen Schalter (1), mindestens eine Energiequelle (11) und mindestens einen elektrischen Verbraucher (12). Die Erfindung betrifft ferner ein Verfahren zum Betreiben eines derartigen elektronischen Schalters (1) oder eines derartigen Energieversorgungssystems (10), wobei der Halbleiterschalter (2) des elektronischen Schalters (1) zumindest zeitweise im Linearbetrieb betrieben wird.

## Beschreibung

Die Erfindung betrifft einen elektronischen Schalter aufweisend einen Halbleiterschalter mit einer Ansteuerschaltung. Weiter betrifft die Erfindung ein Energieversorgungssystem aufweisend einen derartigen elektronischen Schalter, mindestens eine Energiequelle und mindestens einen elektrischen Verbraucher. Die Erfindung betrifft ferner ein Verfahren zum Betreiben eines derartigen elektronischen Schalters oder eines derartigen Energieversorgungssystems.

Schalter werden heutzutage unter anderem dazu genutzt, um in Energieversorgungssystemen elektrische Verbraucher vom Netz trennen zu können. Ebenso ist es mit Hilfe des Schalters möglich, Teile eines Energieversorgungsnetzes abzuschalten. Das Abschalten kann dabei aus betrieblichen Gründen vorgenommen werden oder auch zum Schutz von Komponenten des Energieversorgungsnetzes bei Auftreten eines Fehlers.

Energieverteilungssystem sind heutzutage meistens als AC Netze ausgeführt. Verschiedene Spannungsebenen können dann auf einfache Weise mittels Transformatoren realisiert werden. Der Schutz einzelner Abgänge oder der einzelnen Spannungsebenen wird dabei über mechanische Schalter realisiert. Dabei wird in einem EIN Zustand eine leitende Verbindung geschaffen, während im AUS Zustand die Eingangs- und Ausgangsanschlüsse des Schalters voneinander elektrisch isoliert sind. Die Umschaltung zwischen EIN und AUS Zustand erfolgt im mechanischen Schalter durch die Bewegung eines stromleitenden Elements.

Neben mechanischen Schaltern sind auch Schalter auf Basis von Halbleiterschaltern bekannt. Diese Schalter werden auch als elektronische Schalter bezeichnet. Sie zeichnen sich dadurch aus, dass diese sehr schnell schalten können. Darüber hinaus benötigen diese Schalter für das Abschalten keinen Stromnulldurchgang, so dass sich diese elektronischen Schalter auch insbesondere für die Anwendung in einem Gleichspannungsnetz eignen. Die geringeren Induktivitäten aufgrund fehlender Transformatoren in Gleichspannungsnetzen bewirken große Stromanstiegsgeschwindigkeiten, die ein schnelles Abschalten erforderlich machen, bevor unzulässig hohe Stromstärken erreicht werden.

Der Erfindung liegt die Aufgabe zugrunde, einen elektronischen Schalter zu verbessern.

Diese Aufgabe wird durch einen elektronischen Schalter aufweisend einen Halbleiterschalter mit einer Ansteuerschaltung gelöst, wobei die Ansteuerschaltung derart ausgebildet ist, den Halbleiterschalter in einem eingeschalteten Zustand, in einem ausgeschalteten Zustand oder im Linearbetrieb zu betreiben. Diese Aufgabe wird ferner durch ein Energieversorgungssystem aufweisend einen derartigen elektronischen Schalter, mindestens eine Energiequelle und mindestens einen elektrischen Verbraucher gelöst. Weiter wird diese Aufgabe durch ein Verfahren zum Betreiben eines derartigen elektronischen Schalters oder eines derartigen Energieversorgungssystems gelöst, wobei der Halbleiterschalter des elektronischen Schalters zumindest zeitweise im Linearbetrieb betrieben wird.

Weitere vorteilhafte Ausgestaltungen der Erfindung sind in den abhängigen Ansprüchen angegeben.

Der Erfindung liegt die Erkenntnis zugrunde, dass sich ein elektronischer Schalter dadurch verbessern lässt, dass dieser neben den bereits von einem mechanischen Schalter bekannten Zuständen EIN und AUS, auch als eingeschalteter Zustand und ausgeschalteter Zustand sowie leitender Zustand und nichtleitender Zustand bezeichnet, einen dritten Zustand einnehmen kann, bei dem der Halbleiterschalter des elektronischen Schalters im Linearbetrieb betrieben wird. Dabei befindet sich der Arbeitspunkt des Halbleiterschalters in einem linearen Bereich. Dieser wird auch als Verstärkungsbereich bezeichnet. Beim Linearbetrieb fließt ein Strom durch den Halbleiter und an den Anschlussklemmen, zwischen denen die Schalthandlung vorgenommen wird, liegt eine Spannung an. In diesem dritten Zustand fallen beim elektronischen Schalter elektrische Verluste, vergleichbar mit denen eines Widerstands an. Diese ergeben sich aus dem Produkt vom Strom durch den elektronischen Schalter multipliziert mit der Spannung, die über den elektronischen Schalter anliegt. Die Schaltzustände EIN und AUS führen zu keinen nennenswerten Verlusten, da entweder kein Strom fließt oder keine Spannung am elektronischen Schalter anliegt, so dass das Produkt aus Strom und Spannung zu null wird. Daher werden für Anwendungen in der Leistungselektronik, wie beispielsweise Stromrichter, Gleichstromsteller, etc., nur die beiden Schaltzustände EIN und AUS genutzt, um die Verluste gering zu halten. Durch Anpassung der Ansteuerschaltung ist es jedoch möglich, den elektronischen Schalter in den dritten Zustand, den Linearbetrieb, zu versetzen, bei dem sowohl eine Spannung über den Schalter abfällt als auch ein Strom durch diesen Schalter fließt. Da dieser vergleichsweise hohe Verluste erzeugt, wird dieser Zustand in der Leistungselektronik bisher nicht verwendet.

Mit dem Linearbetrieb können darüber hinaus gezielt Verluste in das Energieversorgungssystem eingebracht werden. Diese können beispielsweise zur Reduzierung von unerwünschten Strömen genutzt werden. Bei unerwünschten Strömen handelt es sich beispielsweise um zu hohe Ströme, die Komponenten im Energieversorgungssystem schädigen oder zerstören können, oder um Ströme, die aufgrund ihrer Frequenz nicht zur Energieübertragung beitragen. Diese Ströme werden auch als Blindströme bezeichnet und treten beispielsweise aufgrund von Schwingungen auf, bei denen Energiespeicher des Energieversorgungssystems in Wechselwirkung stehen und Energie austauschen, die zwischen diesen Energiespeichern pendelt. Diese belasten das Energieversorgungssystem, ohne zur gewünschten Energieübertragung zwischen den Energiequellen und den elektrischen Verbrauchern beizutragen.

In einem Energieversorgungssystem treten beispielsweise dann hohe Ströme auf, wenn kapazitive Lasten, d.h. elektrische Verbraucher mit kapazitivem Verhalten an das Netz angeschlossen werden. Als Beispiel hierfür sind Stromrichter oder Gleichstromsteller wie DC/DC Wandler zu nennen. Diese weisen einen Kondensator auf, der sich beim Verbinden mit einer Energiequelle auflädt. Dabei entstehen teilweise recht hohe Ladeströme. Diese Ladeströme werden oftmals mit Hilfe von Vorladewiderständen begrenzt. Auf diese Vorladewiderstände kann verzichtet werden, wenn der elektronische Schalter einen zu hohen Strom erkennt oder wenn, beispielsweise anhand der Stromsteilheit, der elektronische Schalter die Entstehung eines potenziell zu hohen Stromes erkennt. In diesem Fall wird der elektronische Schalter im Linearbetrieb betrieben. Dadurch werden die Aufladeströme, die sich beispielsweise durch das Aufladen von Kapazitäten ergeben, begrenzt. Auf spezielle Vorladewiderstände kann dann verzichtet werden. Der Arbeitspunkt des Halbleiterschalters kann dabei so angepasst werden, dass die Aufladung mit dem maximal zulässigen Strom erfolgt. Dadurch kann eine schnelle Aufladung des Kondensators erreicht werden.

Ebenso ist es möglich, bei allen Schalthandlungen, die einen hohen Strom, insbesondere einen Aufladestrom erwarten lassen, den Halbleiterschalter des elektronischen Schalters für eine vorgegebene Zeitspanne im Linearbetrieb zu betreiben. Dann kann auf die Erkennung zu hoher Ströme oder potenziell zu hoher Ströme verzichtet werden.

Ebenso kann der elektronische Schalter zur Begrenzung von Anlaufströmen genutzt werden, die sich beim Starten eines Motors ergeben, der direkt, d.h. ohne Stromrichter, mit einer Energiequelle verbunden wird. Auch hier wird der elektronische Schalter bis zum Erreichen einer bestimmten Drehzahl im Linearbetrieb betrieben, um die Anlaufströme zu begrenzen.

Dabei kann in einer vorteilhaften Ausgestaltung mit steigender Drehzahl des Motors der Arbeitspunkt des Linearbetriebs so angepasst werden, dass der Motor mit seinem maximal zulässigen Strom gespeist wird. Dies ermöglicht einen schnellen Übergang von der Anlaufphase des Motors in die Betriebsphase.

Des Weiteren besteht immer die Möglichkeit, beispielsweise aufgrund von Schaltvorgängen, im Energieversorgungssystem vorhandene Resonanzen anzuregen. Diese Resonanzen können aufgrund der Wechselwirkung von induktiven Komponenten (Stromschienen, Transformatoren, elektrische Verbraucher, Energiequellen, Netzfilter, etc.) und kapazitiven Komponenten (parallele Stromschienen, Wicklungskapazität der Transformatoren, elektrische Verbraucher, Energiequellen, Netzfilter, Stützkondensatoren etc.) im Energieversorgungssystem vorhanden sein. Die Anregung kann beispielsweise durch das Einschalten des elektronischen Schalters verursacht werden und zeigt sich in Schwingungen im Strom und/oder Spannungsverlauf im Energieversorgungssystem. Daneben gibt es eine Vielzahl weiterer Möglichkeiten, die zu Schwingungserscheinungen im Energieversorgungssystem führen. Diese Schwingungen lassen sich durch Dämpfungswiderstände im Energieversorgungssystem dämpfen. Diese erzeugen dann Verluste und reduzieren die Wirtschaftlichkeit des Energieversorgungssystems herabsetzen. Die Schwingungen lassen mit Hilfe des elektronischen Schalters im Linearbetrieb begrenzen und abbauen. Der Vorteil liegt unter anderem darin, dass der Linearbetrieb nur bei Vorliegen der Schwingungen durchgeführt wird und nur zu dieser Zeit Verluste erzeugt. Wenn keine Schwingungen vorhanden sind, wird der elektronische Schalter im eingeschalteten Zustand oder im ausgeschalteten Zustand betrieben und der elektronische Schalter arbeitet zumindest nahezu verlustlos. Auf Dämpfungswiderstände, die kontinuierlich Verluste im Energieversorgungssystem erzeugen, kann verzichtet werden.

Durch den Einsatz eines elektronischen Schalters mit der Möglichkeit, diesen im Linearbetrieb zu betreiben benötigt das Energieverteilungssystem keine Widerstände mehr. Vorladewiderstande, Anlaufwiderstände und Dämpfungswiderstände können durch den Linearbetrieb des elektronischen Schalters ersetzt werden. Das Verhalten der Widerstände ist nur aktiv, wenn es benötigt wird. Dadurch werden permanente Verluste vermieden.

Somit wird ein Zustand des Halbleiterschalters, der auf den ersten Blick in der Leistungselektronik aufgrund der Verluste als sehr nachteilig gilt, für den Betrieb genutzt. Es lassen sich damit die folgenden Vorteile erzielen. Es sind keine Widerstände zur Strombegrenzung, Vorladung, Anlaufstrombegrenzung, Schwingungsdämpfung, Spannungsabbau mehr erforderlich. Dadurch ergeben sich geringere Kosten, weniger Platzbedarf und eine höhere Zuverlässigkeit und Verfügbarkeit durch weniger Komponenten. Da die beschriebenen Zustände, in denen der Linearbetrieb des elektronischen Schalters aktiv ist, nur von kurzer Zeitdauer sind, ergeben sich keine oder wenn überhaupt nur geringe Anforderungen an die Kühlung des elektronischen Schalters. Falls eine Kühlung für den elektronischen Schalter vorgesehen wird, hat es sich als vorteilhaft erwiesen, den hier vorgeschlagenen elektronischen Schalter mit einem Kühlkörper für die Kühlung mit Luft auszustatten. Dieser besitzt eine hohe Wärmekapazität und eignet sich daher im Besonderen für die Aufnahme und das Abführen kurzzeitig anfallender elektrischer Verluste.

Bei einer vorteilhaften Ausgestaltung der Erfindung ist der elektronische Schalter als Vorladewiderstand und/oder Anlaufwiderstand und/oder Dämpfungswiderstand betreibbar. Der Arbeitspunkt im Linearbetrieb des Halbleiterschalters kann so gewählt werden, dass der Arbeitspunkt dem Verhalten eines Widerstands entspricht. Somit kann ein Widerstandswert vorgegeben werden, der durch die Ansteuerschaltung in einen Arbeitspunkt des Halbleiterschalters im linearen Bereich umgewandelt wird, bei dem sich eine Spannung am Halbleiterschalter und ein Strom durch den Halbleiterschalter einstellt, dessen Quotient dem Widerstandswert entspricht. Durch die Regelung auf der Basis von Widerständen lassen sich auf einfache Weise bereits vorhandene Widerstände im Energieversorgungsystem ersetzen. Auch kann eine Auslegung der Dämpfung im System, die sich auf der Basis von Widerständen ergibt, beispielsweise mit Hilfe eines Berechnungstools für elektrische Netzwerke, auf einfache Weise durch den elektronischen Schalter umgesetzt werden. Ebenso können durch Berechnungen Bereiche von Widerstandswerten festgelegt werden, in denen das Energieversorgungssystem stabil betrieben werden kann. Damit wird sichergestellt, dass auch die Regelung/Steuerung auf der Basis von Widerstandswerten zuverlässig und stabil funktioniert.

Bei einer weiteren vorteilhaften Ausgestaltung der Erfindung weist der elektronische Schalter einen Stromsensor und/oder einen Spannungssensor auf, wobei in Abhängigkeit von einem Messwert des Stromsensors und/oder des Spannungssensors der Halbleiterschalter des elektronischen Schalters im Linearbetrieb betreibbar ist. Ebenso kann das Energieversorgungssystem mindestens einen Stromsensor und/oder einen Spannungssensor aufweisen, wobei in Abhängigkeit von einem Messwert des Stromsensors und/oder des Spannungssensors der Halbleiterschalter des elektronischen Schalters im Linearbetrieb betreibbar ist. Bei dem Stromsensor und/oder einen Spannungssensor des Energieversorgungssystems kann es sich um den Sensor des elektronischen Schalters handeln. Ebenso ist es möglich, alternativ den entsprechenden Sensor an einer anderen Stelle im Energieversorgungssystem anzuordnen. Des Weiteren ist es auch möglich, sowohl im elektronischen Schalter als auch an einer anderen Stelle des Energieversorgungssystems jeweils einen entsprechenden Sensor anzuordnen.

Für das Betreiben eines derartigen elektronischen Schalters oder eines derartigen Energieversorgungssystems hat es sich als vorteilhaft erwiesen, dass der Halbleiterschalter des elektronischen Schalters im Linearbetrieb betrieben wird, wenn ein Messwert des Stromsensors und/oder des Spannungssensors einen vorgegebenen Grenzwert überschreitet.

Zum Erkennen von Überströmen, d.h. unzulässig hohen Strömen, und Schwingungen, insbesondere Strom- oder Spannungsschwingungen, die eine bestimmte Frequenz besitzen, hat es sich bewährt, im elektronische Schalter und gegebenenfalls zusätzlich oder alternativ im Energieversorgungssystem entsprechende Sensoren, insbesondere Stromsensoren und/oder Spannungssensoren, anzuordnen. Diese sind derart angeordnet, dass sie Ströme erfassen, die durch den elektronischen Schalter zumindest teilweise beeinflussbar sind. Damit kann sichergestellt werden, dass der Linearbetrieb des Halbleiterschalters und die damit einhergehenden Verluste und entsprechende Erwärmung nur dann aktiv ist, wenn er wirklich benötigt wird. Alternativ, ohne Verwendung von Strom- oder Spannungssensoren, kann der Linearbetrieb immer dann vorgesehen werden, wenn Schalthandlungen des elektronischen Schalters vorgenommen werden. Dabei kann zwischen dem eingeschalteten Zustand und dem ausgeschalteten Zustand für eine vorgebbare Zeitspanne der Linearbetrieb vorgesehen werden. Damit können gerade Schwingungen bei Schaltvorgängen, sowie Aufladeströme oder Anfahrströme zuverlässig gedämpft werden, ohne sie vorher detektieren zu müssen.

Bei einer weiteren vorteilhaften Ausgestaltung der Erfindung ist das Energieversorgungssystem als Gleichspannungsnetz ausgebildet. Für ein Gleichspannungsnetz ist die Verwendung des vorgeschlagenen elektronischen Schalters aus verschiedenen Gründen besonders vorteilhaft. Allein schon wegen der geringen Induktivitäten im Energieversorgungssystem aufgrund fehlender Transformatoren ist ein schneller Schalter wegen der großen Stromanstiegsgeschwindigkeiten vorteilhaft. Diese Anforderung an schnelles Schalten kann der elektronische Schalter erfüllen.

Darüber hinaus werden Stromrichter und Gleichspannungssteller (DC/DC Wandler) direkt mit ihrem Zwischenkreis und damit mit ihrem Zwischenkreiskondensator mit dem Gleichspannungsnetz verbunden. Dabei entstehen hohe Ausladeströme, die mit dem vorgeschlagenen elektronischen Schalter im Linearbetrieb zuverlässig beherrscht und reduziert werden können. Ebenso weist das Gleichspannungsnetz oftmals Stützkondensatoren auf, die zur Pufferung der Netzspannung verwendet werden. Auch diese erzeugen beim Schalten hohe Ladeströmen, die vom elektronischen Schalter sicher beherrscht und reduziert werden können. Bei den Stützkondensatoren handelt es sich um verteilt im Energieversorgungssystem angeordnete Kondensatoren, welche die Spannung zwischen den Stromschienen stützen, d.h. konstant halten sollen oder zumindest Spannungsschwankungen reduzieren.

Diese Stützkondensatoren können mit den Leitungsinduktivitäten schwingfähige Systeme bilden, bei denen Schwingungen von Strömen auftreten können. Auch diese können durch den elektronischen Schalter im Linearbetrieb auf einfache Weise gedämpft und beseitigt werden. Die dabei entstehenden Verluste durch das dämpfende Verhalten fallen nur an, wenn die Dämpfung, d.h. der Linearbetrieb, aktiv ist. Werden Widerstände im Gleichspannungsnetz zur Dämpfung verwendet, so entstehen dauerhaft elektrische Verluste, die den Wirkungsgrad des Energieversorgungssystems reduzieren. Anders formuliert erhöht die Verwendung des elektronischen Schalters aufgrund seiner zeitlich beschränkten Verluste im Linearbetrieb den Wirkungsgrad des Energieversorgungssystems.

Bei einer weiteren vorteilhaften Ausgestaltung der Erfindung wird der Messwert des Stromsensors und/oder des Spannungssensors in einen Gleichanteil und in einen Wechselanteil aufgeteilt, wobei der Halbleiterschalter des elektronischen Schalters im Linearbetrieb betrieben wird, wenn der Gleichanteil des Messwertes des Stromsensors und/oder des Spannungssensors einen ersten vorgegebenen Grenzwert überschreitet und/oder wenn der Wechselanteil des Messwertes des Stromsensors und/oder des Spannungssensors einen zweiten vorgegebenen Grenzwert überschreitet. Die Aufteilung in Gleichanteil und Wechselanteil bietet die Möglichkeit, den unerwünschten Zustand im Energieversorgungssystem genauer zu erfassen und entsprechend selektiv zu reagieren. Während schwingendes Verhalten sich in einem Wechselanteil des Messignals bemerkbar macht, sind Aufladevorgänge oder Anlaufströme an einem Gleichanteil oder niederfrequentem Anteil erkennbar. Auf diese Weise kann zwischen den einzelnen unerwünschten Zuständen im Netz selektiv reagiert werden. Unter anderem ist es auch möglich, unterschiedliche Grenzwerte, beispielsweise einen ersten Grenzwert für Aufladevorgänge und Anlaufströme und einen zweiten Grenzwert für Schwingungen, vorzusehen. Damit lässt sich der elektronische Schalter flexibel an die Anforderungen des Energieversorgungsnetzes anpassen und auslegen.

Bei einer weiteren vorteilhaften Ausgestaltung der Erfindung wird der Wert des Widerstands in Abhängigkeit des Messwertes des Stromsensors und/oder des Spannungssensors festgelegt. Insbesondere wenn die Regelung der Dämpfung anhand von Widerständen ermittelt wird, hat es sich als vorteilhaft erwiesen, wenn dieser Widerstandswert von gemessenen Strömen abhängt. Damit können Störungen schnell ausgeregelt werden. Gleichzeitig kann der Widerstandswert schnell an den Zustand des Energieversorgungssystems, der anhand der Messwerte erkannt werden kann, angepasst werden.

Bei einer weiteren vorteilhaften Ausgestaltung der Erfindung wechselt beim Einschalten des elektronischen Schalters der Halbleiterschalter des elektronischen Schalters in einem ersten Schritt von dem ausgeschalteten Zustand in den Linearbetrieb und in einem zweiten Schritt vom Linearbetrieb in den eingeschalteten Zustand. Gerade dann, wenn keine Sensoren zur Bestimmung des Zustands im Energieversorgungssystem vorhanden sind, kann ein Großteil von zu hohen Strömen und Schwingungen sowie anderen Störungen oder unerwünschten Effekte im Energieversorgungssystem dadurch beseitigt werden, dass beim Schalten von einem ausgeschalteten Zustand zu einem eingeschalteten Zustand über einen Zwischenschritt erfolgt, bei dem der Halbleiterschalter im Linearbetrieb betrieben wird. Dieser Linearbetrieb dämpft Ausgleichvorgänge, die oftmals durch das Zuschalten von elektrischen Komponenten wie elektrische Verbraucher oder Energiequellen entstehen. Unter den Ausgleichsvorgängen sind Schwingungen zwischen Energiespeichern wie beispielsweise Kondensatoren zu verstehen, aber auch Aufladevorgänge von Kondensatoren, die beispielsweise in Form von Zwischenkreiskondensatoren in Stromrichtern vorhanden sind, oder Anlaufströme, die beispielsweise beim Verbinden von ungesteuerten Motoren mit der Energiequelle entstehen. Damit lässt sich auch der elektronischer Schalter auf einfache Weise in ein bestehendes Energieversorgungssystem integrieren ohne dafür neue Messsensoren vorsehen zu müssen.

Im Folgenden wird die Erfindung anhand der in den Figuren dargestellten Ausführungsbeispiele näher beschrieben und erläutert. Es zeigen:
- FIG 1: einen elektronischen Schalter,
- FIG 2: ein Energieversorgungssystem mit einem elektronischen Schalter und
- FIG 3 und FIG 4: einen Zeitverlauf beim Einschalten des elektronischen Schalters.

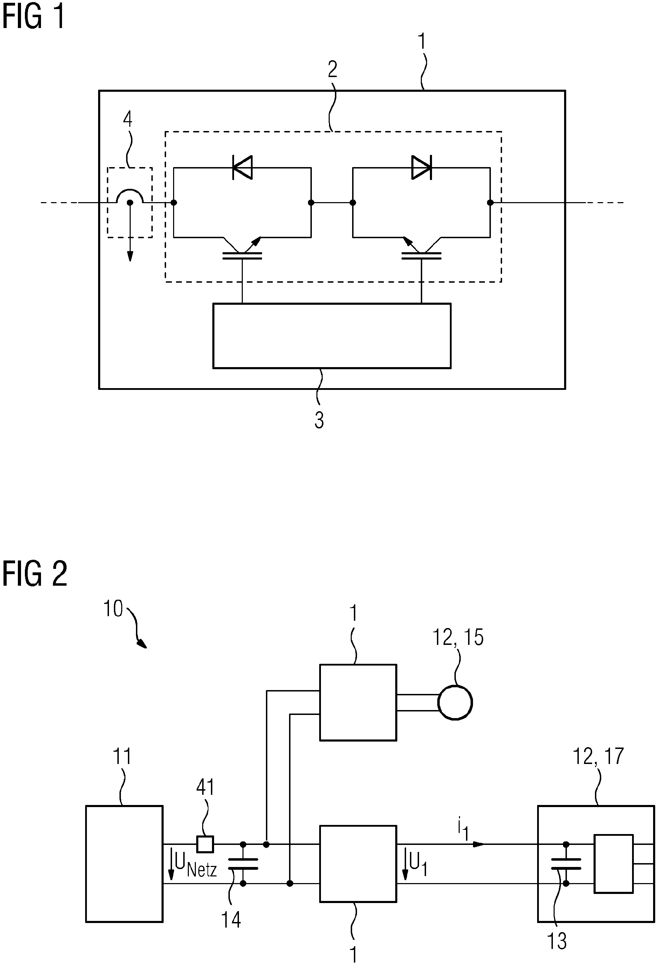

Die FIG 1 zeigt einen elektronischen Schalter 1. Dieser weist einen Halbleiterschalter 2 auf, der mit seinen zwei Halbleitern einen Strom in beide Richtungen führen und abschalten kann. Angesteuert wird der Halbleiterschalter 2 mit seinen Halbleitern von einer Ansteuerschaltung 3. Diese Ansteuerschaltung 3 ermöglicht es, den Halbleiterschalter 2 und damit die darin angeordneten Halbleiter in einen eingeschalteten Zustand, einen ausgeschalteten Zustand und einen Linearbetrieb zu versetzen. Der eingeschaltete Zustand wird auch als leitender Zustand, geschlossener Zustand oder EIN-Zustand bezeichnet. Der ausgeschaltete Zustand wird auch als nichtleitender Zustand, geöffneter Zustand oder AUS-Zustand bezeichnet. Der Linearbetrieb wird auch als Betrieb im linearen Bereich oder als Betrieb im Verstärkungsbereich bezeichnet. Dabei kann, allerdings nicht notwendigerweise, der Halbleiterschalter 2 in Abhängigkeit eines gemessenes Wertes, beispielsweise in Abhängigkeit eines Messwertes eines Stromwandlers 4, von der Ansteuerschaltung 3 in den Linearbetrieb versetzt werden, um zu große Ströme zu verhindern und zu reduzieren oder um Schwingungen zu dämpfen. Dabei kann dann die Auswertung des Messwertes des Stromwandlers 4 in der Ansteuerschaltung 3 oder in einer übergeordneten, hier nicht dargestellten Regelung und/oder Steuerung vorgenommen werden.

Die FIG 2 zeigt ein Energieversorgungssystem 10 mit einer Energiequelle 11 und elektrischen Verbrauchern 12, die jeweils über einen elektronischen Schalter 1 mit der Energiequelle 11 verbunden sind. Das Energieversorgungssystem 10 ist dabei als Gleichspannungsnetz ausgebildet. Zur Stützung der Spannung kann dabei ein Stützkondensator 14 zwischen den beiden Leitern des Gleichspannungsnetzes angeordnet werden. Daneben könne weitere Stützkondensatoren 14 im Energieversorgungssystem verteilt angeordnet sein. Zur Messung von Strömen kann darüber hinaus zusätzlich oder alternativ zu einem Stromsensor 4 im elektronischen Schalter 1 ein weiterer Stromsensor 41 in das Energieversorgungssystem 10 außerhalb des elektronischen Schalters 1 angeordnet werden. Beide elektronische Schalter 1 können den durch den weiteren Stromsensor 41 gemessenen Strom beeinflussen, da dieser zumindest teilweise oder anteilig durch diese elektronischen Schalter 1 fließt.

Beide dieser Stromsensoren 4, 41 können gemeinsam oder nur einer dieser Stromsensoren 4, 41 für die Regelung oder Steuerung des elektronischen Schalters 1 verwendet werden. Aus diesem Grunde wird zwischen dem Stromsensor 4 und dem weiteren Stromsensor 41 nicht weiter unterschieden, sondern diese beide jeweils als Stromsensor 4, 41 bezeichnet. Darüber hinaus ist es auch möglich, den elektronische Schalter 1 und/oder das Energieversorgungssystem 10 sensorlos zu betreiben.

Bei den elektrischen Verbrauchern 12 handelt es sich in einem ersten Beispiel um einen Motor 15 und in einem zweiten Beispiel um einen Stromrichter 17. Der Motor 15 wird über den elektronischen Schalter 1 direkt, d.h. ohne weiteren Steller, mit dem Gleichspannungsnetz verbunden. Beim Einschalten des elektronischen Schalters 1 sind daher hohe Anlaufströme zu erwarten. Ähnlich verhält es sich mit dem Stromrichter 17. Durch den Zwischenkreiskondensator 13 am Eingang des Stromrichters 17 sind auch hier beim Einschalten des entsprechenden elektronischen Schalters 1 hohe Aufladeströme zu erwarten. Sowohl die Anlaufströme als auch die Aufladeströme lassen sich dadurch verringern, dass der Halbleiterschalter 2 des entsprechenden elektronischen Schalters 1 zumindest zeitweise im Linearbetrieb betrieben wird.

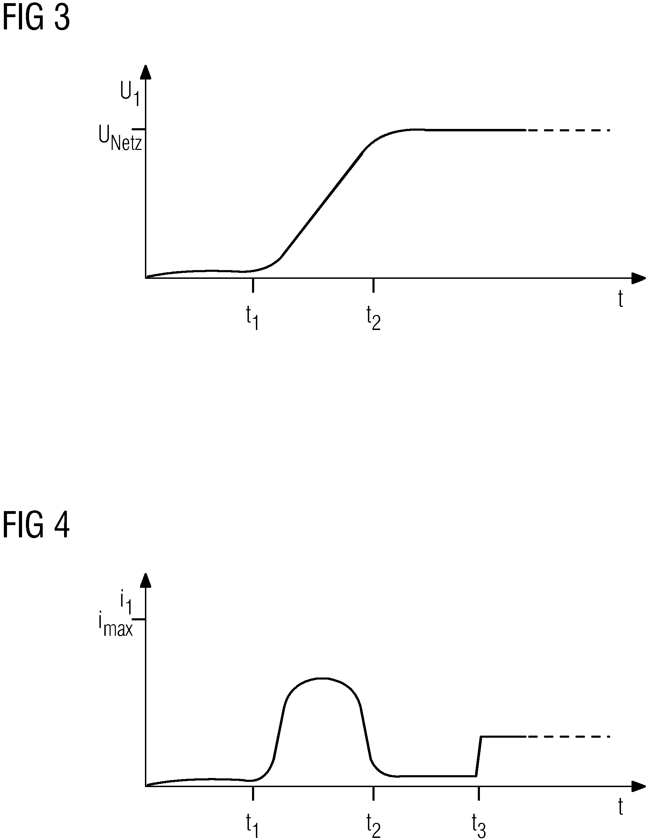

Die in der FIG 2 gezeigten Größen der Netzspannung U_{Netz}, der Spannung U₁ und des Stroms i₁ sollen im Folgenden näher beschrieben werden. Dazu werden in FIG 3 ein Zeitverlauf der Spannung U₁ und in FIG 4 ein Zeitverlauf des Stroms i₁ angegeben, wie er sich beispielsweise beim Verbinden des Stromrichters 17 mit der Energiequelle 11 durch die Steuerung/Regelung ergeben könnte. Diese zeigen die prinzipielle Funktion des elektronischen Schalters 1. Prinzipielle lässt sich dieses Verhalten auch auf andere Verbraucher 12, wie beispielsweise den Motor 15 übertragen.

Bei diesem Zeitverlauf soll der elektronische Schalter 1 eingeschaltet damit der elektrische Verbraucher 12 mit der Energiequelle 11 verbunden werden. Unabhängig, davon, ob es sich bei dem elektrischen Verbraucher 12 um einen Stromrichter 17 oder einen direkt mit dem Gleichspannungsnetz zu verbindenden Motor 15 handelt, sind für den Einschaltmoment hohe Ströme in Form von Aufladeströme oder Anlaufströmen zu erwarten. Daher wird der Halbleiterschalter 2 des elektronischen Schalters 1 zum Zeitpunkt t₁ von der Ansteuerschaltung 3 in den Linearbetrieb überführt. Dies ist daran erkennbar, dass die Spannung U₁ nicht schlagartig auf U_{Netz} wechselt. In diesem Betrieb wird nicht die gesamte Netzspannung U_{Netz} an den elektrischen Verbraucher 12 weitergegeben, sondern fällt zum Teil über den elektronischen Schalter 1 ab. Die dann am Eingang des elektrischen Verbrauchers 12 anliegende geringere Spannung U₁ führt zu einem reduzierten Strom i₁, der in FIG 4 dargestellt ist. Durch diesen Linearbetrieb ist es möglich, den Strom unterhalb eines zulässigen Wertes iₘₐₓ zu begrenzen oder auf den Wert iₘₐₓ zu regeln. Zum Zeitpunkt t₂ sind diese Aufladeströme oder Anlaufströme abgeklungen, da der Zwischenkreiskondensator 13 aufgeladen oder der Motor 15 angelaufen ist. Somit kann zum Zeitpunkt t₂ oder danach der Halbleiterschalter 2 in den eingeschalteten Zustand überführt werden, bei dem im elektronischen Schalter 1 keine nennenswerten elektrischen Verluste mehr auftreten. Ab einem weiteren Zeitpunkt t₃ geht der elektrische Verbraucher in Betrieb und nimmt dabei Energie auf. Dies ist an dem dortigen Stromanstieg erkennbar.

Die im Zeitraum zwischen t₁ und t₂ anfallenden elektrischen Verluste sind nur von kurzer Dauer, so dass diese den elektronischen Schalter 1 nur kurzzeitig erwärmen. Daher kann zumeist auf eine Kühlung verzichtet werden. Falls doch eine Kühlung erforderlich sein sollte, kann diese auf einfache Weise mit einem Luftkühlkörper aufgrund der relativ geringen Verlustenergie zumeist lüfterlos ausgeführt werden.

Zusammenfassend betrifft die Erfindung einen elektronischen Schalter aufweisend einen Halbleiterschalter mit einer Ansteuerschaltung. Um den elektronischen Schalter zu verbessern, wird vorgeschlagen, dass die Ansteuerschaltung derart ausgebildet ist, den Halbleiterschalter in einem eingeschalteten Zustand, in einem ausgeschalteten Zustand oder im Linearbetrieb zu betreiben. Weiter betrifft die Erfindung ein Energieversorgungssystem aufweisend einen derartigen elektronischen Schalter, mindestens eine Energiequelle und mindestens einen elektrischen Verbraucher. Die Erfindung betrifft ferner ein Verfahren zum Betreiben eines derartigen elektronischen Schalters oder eines derartigen Energieversorgungssystems, wobei der Halbleiterschalter des elektronischen Schalters zumindest zeitweise im Linearbetrieb betrieben wird.

## Patentansprüche

1. Elektronischer Schalter (1) aufweisend einen Halbleiterschalter (2) mit einer Ansteuerschaltung (3), wobei die Ansteuerschaltung (3) derart ausgebildet ist, den Halbleiterschalter (2) in einem eingeschalteten Zustand, in einem ausgeschalteten Zustand oder im Linearbetrieb zu betreiben.

2. Elektronischer Schalter (1) nach Anspruch 1, wobei der elektronische Schalter (1) als Vorladewiderstand und/oder Anlaufwiderstand und/oder Dämpfungswiderstand betreibbar ist.

3. Elektronischer Schalter (1) nach einem der Ansprüche 1 oder 2, wobei der elektronische Schalter (1) einen Stromsensor (4) und/oder einen Spannungssensor aufweist, wobei in Abhängigkeit von einem Messwert des Stromsensors (4) und/oder des Spannungssensors der Halbleiterschalter (2) des elektronischen Schalters (1) im Linearbetrieb betreibbar ist.

4. Energieversorgungssystem (10) aufweisend
- einen elektronischen Schalter (1) nach einem der Ansprüche 1 bis 3,
- mindestens eine Energiequelle (11) und
- mindestens einen elektrischen Verbraucher (12).

5. Energieversorgungssystem (10) nach Anspruch 4, wobei das Energieversorgungssystem (10) als Gleichspannungsnetz ausgebildet ist.

6. Energieversorgungssystem (10) nach einem der Ansprüche 4 oder 5, wobei das Energieversorgungssystem (10) mindestens einen Stromsensor (4, 41) und/oder einen Spannungssensor aufweist, wobei in Abhängigkeit von einem Messwert des Stromsensors (4, 41) und/oder des Spannungssensors der Halbleiterschalter (2) des elektronischen Schalters (1) im Linearbetrieb betreibbar ist.

7. Verfahren zum Betreiben eines elektronischen Schalters (1) nach einem der Ansprüche 1 bis 3 oder eines Energieversorgungssystems (10) nach einem der Ansprüche 4 bis 6, wobei der Halbleiterschalter (2) des elektronischen Schalters (1) zumindest zeitweise im Linearbetrieb betrieben wird.

8. Verfahren nach Anspruch 7, wobei der elektronische Schalter (1) einen Stromsensor (4) und/oder einen Spannungssensor gemäß Anspruch 3 oder das Energieversorgungssystem (10) mindestens einen Stromsensor (4, 41) und/oder einen Spannungssensor gemäß Anspruch 6 aufweist, wobei der Halbleiterschalter (2) des elektronischen Schalters (1) im Linearbetrieb betrieben wird, wenn ein Messwert des Stromsensors (4, 41) und/oder des Spannungssensors einen vorgegebenen Grenzwert überschreitet.

9. Verfahren nach einem der Ansprüche 7 oder 8, wobei der Messwert des Stromsensors (4, 41) und/oder des Spannungssensors in einen Gleichanteil und in einen Wechselanteil aufgeteilt wird, wobei der Halbleiterschalter (2) des elektronischen Schalters (1) wird, wenn der Gleichanteil des Messwertes des Stromsensors (4, 41) und/oder des Spannungssensors einen ersten vorgegebenen Grenzwert überschreitet und/oder wenn der Wechselanteil des Messwertes des Stromsensors (4, 41) und/oder des Spannungssensors einen zweiten vorgegebenen Grenzwert überschreitet.

10. Verfahren nach einem der Ansprüche 7 bis 9, wobei durch den Linearbetrieb ein Widerstand nachgebildet wird.

11. Verfahren nach Anspruch 10, wobei der Wert des Widerstands in Abhängigkeit des Messwertes des Stromsensors (4, 41) und/oder des Spannungssensors festgelegt wird.

12. Verfahren nach einem der Ansprüche 7 bis 11, wobei beim Einschalten des elektronischen Schalters (1) der Halbleiterschalter (2) des elektronischen Schalters (1) in einem ersten Schritt von dem ausgeschalteten Zustand in den Linearbetrieb wechselt und in einem zweiten Schritt vom Linearbetrieb in den eingeschalteten Zustand wechselt.
